# EUROPÄISCHE PATENTSCHRIFT

(11) **EP 1 883 962 B1**
(45) Veröffentlichungstag und Bekanntmachung des Hinweises auf die Patenterteilung: **02.03.2011**
(21) Anmeldenummer: 06742995.1
(22) Anmeldetag: 19.05.2006
(51) Int. Cl.: H01L 23/485

(54) **UBM-PAD, LÖTKONTAKT UND VERFAHREN ZUR HERSTELLUNG EINER LÖTVERBINDUNG**
UBM PAD, SOLDER CONTACT AND METHOD FOR PRODUCTION OF A SOLDER CONNECTION
PASTILLE UBM, CONTACT A BRASER, ET PROCEDE DE PRODUCTION D'UNE LIAISON DE BRASAGE

(30) Priorität: 25.05.2005 DE 102005024088; 28.10.2005 DE 102005051857
(43) Veröffentlichungstag der Anmeldung: 06.02.2008
(73) Patentinhaber: Fraunhofer-Gesellschaft zur Förderung der angewandten Forschung e.V., 80686 München (DE)
(72) Erfinder: JURENKA, Claudia, 10405 Berlin (DE); WOLF, Jürgen, 10439 Berlin (DE); ENGELMANN, Gunter, Dr., 12926 Berlin (DE); REICHL, Herbert, 14193 Berlin (DE)
(74) Vertreter: Stöckeler, Ferdinand
(86) Internationale Anmeldenummer: PCT/EP2006/004783
(87) Internationale Veröffentlichungsnummer: WO 2006/125571

(56) Entgegenhaltungen:
- EP-A- 1 223 613
- US-A- 5 904 859
- US-B1- 6 417 089

## Beschreibung

Die vorliegende Erfindung bezieht sich auf ein Verfahren zur Herstellung von Lötverbindungen zwischen einem UBM-Pad bzw. einem Lötkontakt und einem weiteren Lötpartner, insbesondere im Bereich mikroelektronischer Kontaktierungsverfahren (Flip Chip-Verbindungen).

Die Flip-Chip-Verbindung ist ein gängiges Verfahren zur elektrischen und mechanischen Verbindung eines elektrischen Bauelementes z.B. eines Halbleiter-Chips. Hierfür werden sogenannte Flip-Chip-Bumps (Flip-Chip-Bump = Flip-Chip-Lothügel) eingesetzt. Diese Flip-Chip-Bumps werden auf dem elektronischen Bauelement (IC-Chip) oder auf einem Substrat aufgebracht. Unter einem Chip versteht man in ein elektronische Komponente z.B. aus Silizium (Si), Silizium-Germanium (SiGe), Gallium-Arsenid (GaAs) oder Indium-Phosphit (InP) oder anderen Materialien. Die Flip-Chip-Bumps dienen dabei sowohl zur mechanischen Befestigung des Chips auf dem entsprechendem Substratträger als auch dazu, einen elektrischen Kontakt zwischen dem Chip bzw. der elektronischen Komponente und den Anschlusspads auf dem Substrat zu erzeugen. Es besteht aufgrund bestehender Umweltschutzauflagen die Anforderung, die Flip-Chip-Bumps bzw. Lotbumps in Zukunft mittels bleifreier Verbindungen auszuführen. Somit werden zunehmend bleifreie Materialien z.B. auf einem Substrat, einem Chip oder einem beliebigen elektronischem Bauelement für die Flip-Chip-Technologie eingesetzt.

Dabei erfordert die Anwendung von einem bleifreien Löten bei Flip-Chip-Verbindungssystemen umfassende Kenntnisse auf dem Gebiet von Under-Bump-Metallisierungen (UBMs), Lotmaterialien, Metallisierungen sowie bezüglich der Wechselwirkungen zwischen diesen Komponenten. Dafür in Frage kommende übliche UBMs werden mit verschiedenen bleifreien Lötsystemen ausgeführt und getestet, um die Entstehung und das Wachstum intermetallischer Verbindungen bzw. IMCs (IMCs = Intermetallic Compounds) hinsichtlich ihrer Zuverlässigkeit zu untersuchen. Aufgrund der metallurgischen Reaktion der Materialien und der damit verbundenen Entstehung der IMCs, sind Standard-UBMs auf der Basis von Cu nicht für bleifreie Anwendungen bei erhöhter Temperatur, für Bauelemente mit sehr kleinen Lötverbindungen geeignet. Gegenstand der Erfindung ist es, einen UBM-Aufbau zu beschreiben, der an der Grenzfläche zwischen der UBM-Schichten und dem Lot eine begrenzte bzw. kontrollierte Entstehung von IMCs aufweist.

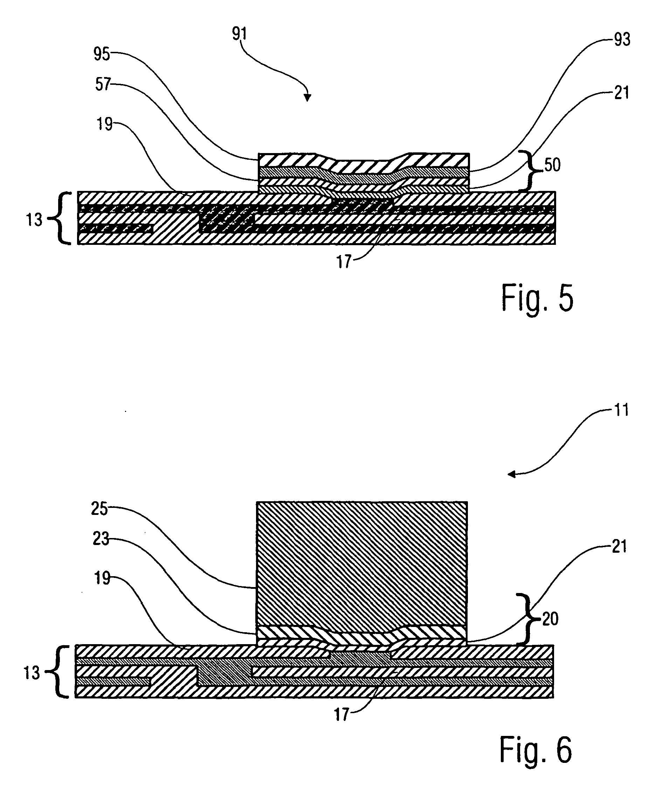

Fig. 6 zeigt den Aufbau eines herkömmlichen Verbindungskontaktes (Bump) 11. Die herkömmliche Bump-Struktur 11 umfasst, eine UBM-Schicht bzw. Under-Bump-Metallisierungs-Schicht 20, bestehend aus einer Haft- und Diffusionssperrschicht 21 und einer Lotbenetzungsschicht 23 und einem Lot 25.

Der Aufbau eines Substrats 13 bzw. der Chips, die in einem Waferverbund sind, ist wie in Fig. 6 gezeigt: die Oberfläche ist durch eine Passivierung 19 geschützt und trägt eine größere Zahl von Anschlusspads 17, bei denen die Passivierung geöffnet ist und die elektrische Verbindung nach außen darstellen. Die Haft- und Diffusionssperrschicht 21 ist auf den Anschlusspads 17 und der Passivierung 19 aufgebracht. Somit ist die Haft- und Diffusionssperrschicht 21 mit den Anschlusspads 17 elektrisch leitend verbunden. Die Lotbenetzungsschicht 23 ist auf der Haft- und Diffusionssperrschicht 21 aufgebracht, während das Lot 25 auf der Benetzungsschicht 23 angeordnet ist.

Die Haft- und Diffusionssperrschicht 21, die Benetzungsschicht 23 und das Lot 25 werden beispielsweise auf Anschlusskontakten bzw. Aluminium-I/O-Pads von ICs im Waferverbund aufgebracht. Das Lot 25 wird durch geeignete Verfahren z.B. galvanisch abgeschieden, während die UBM-Schichten 20 beispielsweise durch Sputtern und/oder Galvanik aufgebracht werden. Teile der UBM-Schichten 20 können bei einem anschließenden galvanischen Prozess als Elektrode dienen, um die Benetzungsschicht 23 zu verstärken. Die Verstärkung wird als eine einlagige Metallisierung ausgeführt. Die UBM-Schichten 20 werden als Haftschicht und Diffusionsbarriere und als Benetzungsfläche für das Lot 25 eingesetzt. Zugleich erfüllen die UBM-Schichten 20 eine technologische Funktion beim Aufbringen des Lots 25 bzw. der Lotbumps bzw. der Kontakthügel auf einem Wafer mittels physikalischer oder chemischer bzw, elektrochemischer Prozesse. Hierbei gibt es eine Vielzahl von Möglichkeiten, die UBM-Schicht 20 bzw. die UBM-Konfiguration auszuführen. Derzeitig gibt es je nach Hersteller sehr unterschiedliche UBM-Konfigurationen.

Verwendet werden in Abhängigkeit vom Bumpmaterial unterschiedliche Under-Bump-Metallisierungs-Systeme bzw. UBM-Schichten 20. Verwendete Materialien sind beispielsweise ein Schichtsystem aus Chrom, Kupfer und Gold (Cr/Cu/Au), ein Schichtsystem aus Chrom, einer Chrom-Kupferverbindung und Kupfer (Cr/CrCu/Cu), ein Schichtsystem aus einer Verbindung von Titan, Wolfram und Kupfer mit Kupfer (TiWCu-Cu), ein Schichtsystem aus Nickel ggf. mit Vanadium und Kupfer (Ni/Cu bzw. NiV/Cu), ein Schichtsystem aus Titan und Nickel ggf. mit Phosphor (Ti/Ni bzw. Ti/NiP), ein Schichtsystem aus einer Verbindung von Titan und Wolfram mit einer Verbindung aus Nickel und Vanadium (TiW-NiV), ein Schichtsystem aus Aluminium, Nickel (Ni, NiP) und Gold (A1/Ni/Au bzw. Al/NiP/Au), ein Schichtsystem aus Titan, einer Verbindung aus Titan und Nickel, mit einer Legierung aus Kupfer und Nickel (Ti/TiNi/Cu-Ni), ein Schichtsystem aus Titan, Nickel und Palladium (Ti/Ni/Pd) oder ein Schichtsystem aus Nickel ggf mit Phosphor, Palladium und Gold (Ni/Pd/Au bzw. NiP/Pd/Au). Das Lot kann dabei als Zinn-Kupfer-Lot (Sn-Cu), Zinn-Silber-(Sn-Ag), Zinn-Gold- (Sn-Au), Zinn-Zink- (Sn-Zn), Zinn-Blei- (Sn-Pb), Zinn-Wismut- (Sn-Bi) oder Zinn-Indium-Mischung (Sn-In) ausgeführt sein.

Die Haft- und Diffusionssperrschicht 21 ist z.B. aus Chrom (Cr), einer Chrom-Kupfer-Mischung (Cr-Cu-Compound = Cr-Cu-Mischung), Titan (Ti), einer Verbindung aus Titan und Wolfram (TiW), einer Verbindung aus Titan, Wolfram und Stickstoff (TiWN) oder aus Aluminium (A1) ausgeführt.

Bei einer metallurgischen Reaktion der Benetzungsschicht 23 mit dem Lot 25, die z.B. bei einem Reflow-Prozess bzw. beim Aufschmelzen auftritt, entstehen durch einen direkten und indirekten Wärmeeinfluss die sogenannten intermetallische Verbindungen (IMC). Diese intermetallischen Verbindungen beeinflussen die Zuverlässigkeit des metallurgischen Gesamtaufbaus einer Lotverbindung. Unter bestimmten Umständen kann es zur Versprödung des Kontakts und damit zu einer Delamination der Lotverbindungen und zu einem Verlust des elektrischen Kontakts führen. Die Ausbildung des Wachstums der intermetallischen Verbindung ist dabei stark von der Auswahl der Metallschicht-Systeme bzw. der Ausführung der UBM-Schicht 23 und des Lots 25 abhängig. Durch den Einsatz von bleifreien Lotverbindungen, wie beispielsweise Verbindungen aus Zinn (Sn), aus Zinn und Silber (SnAg), aus Zinn, Silber und Kupfer (SnAgₓCu_{y}) oder aus Zinn und Kupfer (SnCu) kann in Folge der Veränderung der Grenzflächenenergie durch den erhöhten Zinnanteil (z.B. im Vergleich zu PbSn) eine entsprechend verstärkte Reaktion mit den darunter liegenden Metallschichten auftreten. Dabei kann die Benetzungsschicht 23, die z.B. aus einem Kupfer-Material ausgeführt ist, das beispielsweise ca. 5 um dick ist, vollständig verbraucht werden.

Bei Lotkontakthügeln (Bumps) geringen Volumens ist eine Beschränkung des Wachstums intermetallischer Verbindungen (IMCs) aufgrund der UBM-Lot-Reaktion wesentlich, um die Zuverlässigkeit elektrischer Verbindungen zu erhöhen. Es gibt mehrere Möglichkeiten, den Prozess der Entstehung von IMCs, die z.B. während Flüssig- und Festphasenreaktionen zwischen UBM und bleifreiem Lot auftritt, zu verlangsamen. Es können UBM-Materialien, die eine langsamere Bildung von IMCs als andere zeigen, ausgewählt werden, so wie dies bei Ni im Vergleich zu Cu zutrifft. In diesem Fall wird der Prozess des UBM-Verbrauchs verlangsamt, jedoch nicht unterbunden.

Die Zuverlässigkeit einer Einzelschicht-UBM (z.B. Ni, Cu) kann durch Erhöhen der Schichtdicke der UBM verbessert werden. Für eine Realisierung von Kontakthügeln ist es auch möglich, Lotlegierungen zu verwenden, die den UBM-Verbrauch verlangsamen. Für Lotkontakte mit einer Höhe von z.B. 60 µm bis 80 µm und einer geeigneten Lotlegierungen erweist sich die Al/Ni(V)/Cu-UBM als eine mögliche UBM für bleifreie Lote. Die Dünnfilm-Al/Ni(V)/Cu-UBM wird jedoch nicht erfolgreich mit bleifreien Loten eingesetzt, wenn diese keinen ausreichend großen Cu-Anteil enthalten. Aus der EP1223613 A ist eine Elektrodenstruktur bekannt, bei der eine UBM-Schicht auf einer Kontaktschicht angeordnet ist, wobei zwischen der UBM-Schicht und einem Lötkontakthügel aus Zinn eine Lotlegierungserzeugungsschicht vorgesehen ist. Eine Kombination von intermetallischen Verbindungen wird erzeugt, eine aus Zinn und der Lotlegierungserzeugungsschicht und eine aus Zinn und der UBM-Schicht. Zu diesem Zweck wird die Lotlegierungserzeugungsschicht vollständig in dem Zinn aufgelöst, wobei das Zinn dann gleichzeitig die UBM-Schicht auflöst.

Es ist die Aufgabe der vorliegenden Erfindung, ein Verfahren zur Herstellung einer Lötverbindung zu schaffen, die ein Lötverbindung mit einer hohen Zuverlässigkeit ermöglichen.

Diese Aufgabe wird durch ein Verfahren nach Anspruch 1 gelöst.

Des weiteren schafft die vorliegende Erfindung ein Verfahren zum Herstellen einer Lötverbindung unter Verwendung eines UBM-Pads mit einer ersten Materialschicht, die ein erstes Material aufweist, einer zweiten Materialschicht, die ein zweites Material aufweist und selbst eine Endschicht darstellt oder zwischen einer Endschicht und der ersten Materialschicht angeordnet ist, wobei das erste Material und das zweite Material bezüglich eines Lotmaterials Eigenschaften besitzen, so dass die Anwesenheit des zweiten Materials metallurgische Reaktionen des ersten Materials mit dem Lotmaterial im gesamten Temperaturbereich des Verbindens und des Betriebs des aufgebauten elektronischen Bauelements unterbindet, die der Zuverlässigkeit der Gesamtverbindung abträglich sind, wobei das Lotmaterial auf der Endschicht angeordnet ist, mit einem Erzeugen des Lötkontakts, an einem ersten Lötpartner, einem Positionieren eines zweiten Lötpartners an dem Lötkontakt und einem Durchführen eines Reflow-Lötens, zur Erzeugung einer intermetallischen Verbindung zwischen dem zweiten Material und dem Lotmaterial und zur Zusammenfügung des ersten und zweiten Lötpartners.

Des weiteren schafft die vorliegende Erfindung ein Verfahren zum Herstellen einer Lötverbindung zwischen einem UBM-Pad mit einer ersten Materialschicht, die ein erstes Material aufweist, einer zweiten Materialschicht, die ein zweites Material aufweist und selbst eine Endschicht darstellt oder zwischen einer Endschicht und der ersten Materialschicht angeordnet ist, wobei das erste Material und das zweite Material bezüglich eines Lotmaterials Eigenschaften besitzen, so dass die Anwesenheit des zweiten Materials metallurgische Reaktionen des ersten Materials mit dem Lotmaterial im gesamten Temperaturbereich des Verbindens und des Betriebs des aufgebauten elektronischen Bauelements unterbindet, die der Zuverlässigkeit der Gesamtverbindung abträglich sind mit einem Lötpartner, der ein Lotmaterial aufweist, mit einem Erzeugen des UBM-Pads mit den oben genannten Merkmalen, einem Positionieren des Lötmaterials des Lötpartners an dem UBM-Pad und einem Durchführen eines Reflow-Lötens, zur Erzeugung einer intermetallischen Verbindung zwischen dem zweiten Material und dem Lotmaterial zur Zusammenfügung des UBM-Pads und des Lötpartners.

Die vorliegende Erfindung schafft ein Verfahren zur Herstellung eines Lötkontakts bestehend aus einem Lotmaterial und einer Unterbumpmetallisierungsschicht (UBM) mit einer doppellagigen Benetzungsstruktur, die eine erste Schicht aus einem ersten Material und eine zweite Schicht aus einem zweiten Material aufweist. Die zweite benetzbare Materialschicht ist zwischen dem Lotmaterial und der ersten benetzbaren Materialschicht angeordnet, wobei das Lotmaterial, das erste Material und das zweite Material solcher Art sind, dass bei einer metallurgischen Reaktion das zweite Material und das Lotmaterial eine höhere Bildungsgeschwindigkeit einer intermetallischen Verbindung aufweisen als das erste Material und das Lotmaterial. Außerdem ist ein Anteil des Lotmaterials in einer intermetallischen Verbindung zwischen dem zweiten Material und dem Lotmaterial geringer als ein Anteil des Lotmaterials in einer intermetallischen Verbindung zwischen dem ersten Material und dem Lotmaterial. Zudem weist die zweite Untermetallisierungsschicht eine Dicke auf, die sicherstellt, dass bei einer metallurgischen Reaktion eine derartige Schicht einer intermetallischen Verbindung, die das Lotmaterial und das zweite Material aufweist, zwischen dem Lotmaterial und der ersten benetzbare Materialschicht gebildet wird, so dass die Bildung einer intermetallischen Verbindung zwischen dem ersten Material und dem Lotmaterial nicht auftritt. Die Schicht der intermetallischen Verbindung ist dabei z. B. nahezu durchgehend, so dass die Bildung einer intermetallischen Verbindung zwischen dem ersten Material und dem Lotmaterial nicht auftritt.

Des weiteren ermöglicht die vorliegende Erfindung die Umsetzung eines Verfahrens zur Herstellung einer Lötverbindung unter Verwendung eines Lötkontakts, mit oben erwähnten Merkmalen an einem ersten Lötpartner. Dieses Verfahren schließt ein das Positionieren eines zweiten Lötpartners an dem Lötkontakt dieses ersten Lötpartners, die Erzeugung einer zuverlässigen Lotverbindung des ersten und des zweiten Lötpartners, bei der eine intermetallische Verbindung zwischen dem zweiten benetzbaren Material und dem Lotmaterial des ersten Lötpartners entsteht, die den Verbrauch des ersten benetzbaren Materials des ersten Lötpartners unterbindet, sowie die Erzeugung einer geeigneten Lotlegierung während des Aufschmelzens.

Der vorliegenden Erfindung liegt die Erkenntnis zugrunde, dass eine zweite benetzbare Materialschicht mit vorbestimmten Eigenschaften, die zwischen einem Lotmaterial und einer ersten benetzbare Materialschicht angeordnet ist, der Bildung einer intermetallischen Verbindung zwischen einem Material der ersten benetzbare Materialschicht und dem Lotmaterial unterbindet oder stark einschränkt.

Das Verfahren der vorliegenden Erfindung schafft einen Lötkontakt, der beispielsweise durch physikalisch-chemische Prozesse, wie Sputtern, Aufdampfen und Galvanik, als ein Mehrlagensystem von Metallen realisiert werden kann, die unterschiedliche metallurgische Eigenschaften gegenüber bleifreiem Lot zeigen. Durch einen geeigneten Aufbau und entsprechende Wahl der einzelnen Schichtdicken dieser Mehrfachmetall-Lagensysteme ist es möglich, ein stabiles Interface für Lote, beispielsweise bleifreie Lote, wie Sn, SnCu, SnAg, SnAg(x)Cu(y), zu einem darunter liegenden Metallsystem zu erreichen. Durch die Wahl geeigneter Schichtdicken und Metallisierungssystemen kann dabei das Wachstum der auszubildenden intermetallischen Verbindungen begrenzt, eingeschränkt bzw. frühzeitig gestoppt werden, so dass keine vollständige Umsetzung in intermetallische Verbindungen zumindest einer der benetzbaren Metallisierungslagen, vorzugsweise der einem Wafer bzw. Chip zugewandten Metallisierung, also der dem Lot abgewandten Lage, während des Betriebs der Bauteile stattfindet. Anders ausgedrückt soll eine vollständige Umsetzung zumindest einer der benetzbaren Metallisierungslagen sowohl während der Flüssigphasenreaktion bei einem Umschmelzen (z.B. Reflow-Löten) als auch während einer Festphasenreaktion im nachfolgenden Betrieb unterbunden werden.

Die Dimensionierung der Schichtdicken ist dabei abhängig von dem erforderlichen Lotvolumen und der Löslichkeit des jeweiligen Metalls im Lot bei der Temperatur, bei der die metallurgische Reaktion durchgeführt wird. Entsprechende Daten bezüglich der Löslichkeit sind aus der Literatur bekannt.

Zur Vereinfachung wird im Folgenden bzgl. der UBM das erste Material der ersten benetzbaren Materialschicht mit M1 bezeichnet, während das zweite Material der zweiten benetzbaren Materialschicht mit M2 bezeichnet wird. Des weiteren wird eine intermetallische Verbindung (intermetallische Phase) aus Komponenten des Lots und M1 mit IMC M1 bezeichnet und eine intermetallische Verbindung aus Komponenten des Lots und M2 mit IMC M2 bezeichnet.

Grundsätzlich sind beide Metallisierungen bzw. Materialien M1 und M2 in der Lage, mit den Komponenten des Lots intermetallische Verbindungen zu bilden. Erfindungsgemäß sind die Materialien M1 und M2 so gewählt, dass bei einer metallurgische Reaktion das zweite Material und das Lotmaterial eine höhere Bildungs- und/oder Wachstumsgeschwindigkeit einer intermetallischen Verbindung aufweisen als das erste Material und das Lotmaterial. Das zweite Material stellt dabei das Material der dem Lot direkt ausgesetzten bzw. zugewandten Metallisierungsschicht dar. Die Bildungs- und/oder Wachstumsgeschwindigkeit von IMC M2 erfolgt somit während der Flüssigphasenreaktion (bzw. einer Festphasenreaktion) schneller als die von IMC M1, so dass M2 als Opferschicht während des Reflow-Lötens wirkt, in IMC M2 umgewandelt wird und sich zwischen Lot und der darunter liegenden Metallisierung M1 befindet. Durch die Eigenschaft, dass M2 bei der Umsetzungsreaktion mit dem Lot ein vergleichsweise schnelleres Wachstum, bzw. eine schnellere Bildung von intermetallischen Verbindungen bei der Temperatur, bei der die metallurgische Reaktion stattfindet, aufweist, kann somit erreicht werden, dass die auszubildende metallische Verbindung eine nahezu dichte Schicht ergibt, so dass die dem Lot abgewandte Metallisierung der ersten benetzbaren Materialschicht (M1) nicht in direktem Kontakt mit dem Lot steht.

Erfindungsgemäß ist ferner der Anteil der aus dem Lot stammenden Komponenten in einer intermetallischen Verbindung, die sich aus einer Flüssigphasenreaktion zwischen M1 und Lot ergibt, höher als in der intermetallischen Verbindung, die aus einer Flüssigphasenreaktion von M2 und Lot hervorgeht. Somit kann verhindert werden, dass an einer Grenzfläche von IMC M2 zu M1 eine intermetallische Verbindung IMC M1 erzeugt wird. Vielmehr kann hier in der intermetallischen Verbindung IMC M2 lediglich ein teilweiser Ersatz des Materials M2 durch das Material M1 bis zu einer bestimmten Sättigung erfolgen. Die sich ergebende ternäre Phase (3-Phasen-System) trägt jedoch noch immer zu einer nahezu geschlossenen Trennschicht bei.

Die Morphologie der sich ausbildenden intermetallischen Verbindung an der Grenzefläche zwischen benetzbaren Materialschichten und Lot ist abhängig von den Komponenten, die an ihrer Bildung und Zusammensetzung beteiligt sind. Die Ausbildung der intermetallischen Verbindungen an der Grenzfläche zwischen benetzbaren Materialschichten und Lot konkurriert während der Flüssigphasenreaktion mit der Lösung der angebotenen Metallisierung im Lot. Aufgrund dieser Tatsache ist neben der Löslichkeit des Metalls M2 im Lot bei der Temperatur während des Reflow-Lötens die Morphologie der intermetallischen Verbindungen zu betrachten, wobei erfindungsgemäß eine intermetallische Verbindung, die das Lot und M2 aufweist, eine nahezu dichte Schicht zwischen Lot und M1 darstellen soll, so dass eine Reaktion zwischen diesen beiden Komponenten unterbunden wird.

Erfindungsgemäß weist die zweite benetzbare Materialschicht eine Dicke auf, die sicherstellt, dass bei einer metallurgischen Reaktion eine durchgehende Schicht einer intermetallischen Verbindung, die das Lotmaterial und das zweite Material aufweist, zwischen dem Lotmaterial und der ersten Materialschicht gebildet wird. Die Schicht der intermetallischen Verbindung kann sich dabei weitgehend durchgehend ausbilden, dass nur eine intermetallische Verbindung zwischen M2 und dem Lot ausgebildet wird. Die zweite benetzbare Materialschicht, die während des Reflow-Lötens in ein oder mehrere intermetallische Verbindungen umgewandelt werden soll, wird dabei so aufgelegt, dass das Verhältnis ihrer Masse zur Masse des Lots größer ist, als die Löslichkeit ihres Metalls im Lotsystem, und zwar bei der Temperatur, bei der das Reflow-Löten stattfindet, d.h. beim Aufschmelzen des Lots. Im optimalen Fall kann durch eine geeignete Wahl der Schichtdicke sichergestellt werden, dass nur eine intermetallische Verbindung zwischen M2 und Lot ausgebildet wird.

Mit anderen Worten wird zur Stabilisierung des Systems, d.h. des Lotkontakts nach dem Reflow-Löten, eine geschlossene Schicht intermetallischer Verbindungen durch das Reflow-Löten erzielt, an deren Bildung in erster Linie M2 und Komponenten aus dem Lot beteiligt sind, d.h. der Anteil von M1 an der intermetallischen Verbindung kleiner oder gleich ist dem Löslichkeitsmaximum von M1 in der intermetallischen Verbindung aus M2 und den Komponenten des Lots. Somit kann diese Schicht eine topologische Trennung von Lot und M1 bewirken, um eine direkte Umsetzung von M1 mit Komponenten des Lots bei Temperaturen, während denen das Lot als flüssige Phase vorliegt, im optimalen Fall zu unterbinden, bzw. den direkten Kontakt von Lot und M1 zu vermeiden und den Nachschub von Lot zu M1 zu verhindern. Dadurch wird während des Reflow-Lötens die Bildung von intermetallischen Verbindungen, an denen hauptsächlich M1 und Komponenten des Lots beteiligt sind, unterbunden. Ferner wirkt während des Betriebs von Bauteilen die intermetallische Verbindung zwischen Lot und M2 als Diffusionsbarriere, so dass im optimalen Fall die Bildung und das Wachstum neuer intermetallischer Verbindungen am Interface, d.h. an der Grenzfläche zwischen intermetallischer Verbindung und nicht-umgesetzter Metallisierungslage, verhindert werden kann.

Um die Erzeugung einer geschlossen Schicht intermetallischer Verbindungen der genannten Art zu ermöglichen, ist die Schichtdicke der beteiligten Metallisierungen und, in erster Linie, die Schichtdicke der Opferschicht, dem Lotvolumen und der Lotzusammensetzung anzupassen. Eine Solldicke kann dabei als eine Dicke definiert werden, bei der das Verhältnis der Masse der Metallisierung M2 zur Masse des Lots, bezogen auf die Verhältnisse an einem Bump (Lötkontakthügel) dem Löslichkeitsmaximum von M2 im Lot bei der maximalen Temperatur entspricht, die während des Reflow-Lötens im Bump erreicht wird.

Bei dem Ausführungsbeispiel ist das erste Material, das die erste benetzbare Materialschicht aufweist, Nickel, während das zweite Material, das die zweite benetzbare Materialschicht aufweist, Kupfer ist. Als Lot können dabei beispielsweise Sn oder Legierungen aus den Systemen SnAg und CuSn zur Anwendung kommen. Alternativ zu den angesprochenen bleifreien Lotsystemen, für die die vorliegende Erfindung vorteilhaft einsetzbar ist, ist eine Anwendung des entwickelten UBM-Systems (UBM = Under Bump Metallization) auch für nicht-bleifreie Lotsysteme, beispielsweise PbSn, möglich.

Das Mehrlagen-UBM-System kann durch Kombination von physikalischen, elektrochemischen und/oder chemischen Prozessen realisiert werden. Bei den Ausführungsbeispielen der Erfindung werden die Mehrfach-UBM-Schichten durch Sputtern und galvanische Abscheidung erzeugt. Das Mehrlagen-UBM-System ist nicht auf zwei benetzbare Materialschichten beschränkt. Es können mehr als zwei benetzbare Materialschichten beteiligt sein, die eine entsprechende Stabilisierung bewirken. Dabei ist die erste benetzbare Materialschicht die am weitesten von dem Lotmaterial beabstandete benetzbare Materialschicht, wobei die dazwischen angeordneten Schichten die oben bezüglich der zweiten benetzbaren Materialschicht beschriebenen Eigenschaften aufweisen. Ferner kann jede der Schichten zu der jeweils benachbarten, weiter von dem Lotmaterial beabstandeten Schicht die Eigenschaften aufweisen, die oben bezüglich der zweiten und ersten benetzbaren Materialschicht beschrieben wurden.

Wie beschrieben wurde, ist der Aufbau des UBM-Systems und insbesondere die Wahl der Stärke der zweiten benetzbaren Materialschicht entsprechend der Lotmasse und damit der Größe der Bumps und der Lotzusammensetzung anzupassen. Entscheidend ist hier das Verhältnis von Lotmasse zu Masse des Materials der zweiten benetzbaren Materialschicht, beim bevorzugten Ausführungsbeispiel Kupfer. Als Haftschicht zwischen dem Lötkontakt und einem auf einem Substrat angeordneten Anschlussfläche können Dünnschichtsysteme, beispielsweise Ni:V, Ti, Cr, CrCu, u.a. eingesetzt werden. Von erfindungsgemäßer Bedeutung ist das Mehrschichtsystem, das dem Lot ausgesetzt ist, bei Ausführungsbeispielen der Erfindung die Doppelschicht aus Ni und Cu.

Das UBM-System ist anwendbar für die Montage, d.h. bevorzugt das Löten, elektronischer Komponenten und Halbleiterchips unter Verwendung von kleinen und dünnen Kontaktsystemen. Das Prinzip ist grundsätzlich auf alle Lotverbindungen auch außerhalb der Flip-Chip-Kontaktierung anwendbar, bevorzugt jedoch in der Halbleiter- und Mikrosystemtechnik..

Der UBM-Aufbau ermöglicht zahlreiche Verbesserungen und Vorteile. So wird eine prozesskompatible Realisierung eines stabilen Interface, d.h. einer stabilen Kontaktstelle, in der Under-Bump-Metallisierung für bleifreie Lotverbindungen für die Flip-Chip-Montage von Halbleiterbauelementen, im Allgemeinen beim sogenannten Wafer-Processing, erreicht. Die Zuverlässigkeit des Kontaktsystems wird durch eine Reduzierung und Stabilisierung der Verbindungsbildung an der Grenzfläche zwischen Lot und Under-Bump-Metallisierung erhöht. Ferner kann durch eine Variation der Schichtdicken des Mehrlagen-UBM-Systems eine Anpassung an verschiedene bleifreie Lotsysteme erfolgen, beispielsweise an unterschiedliche Lotlegierungen wie SnAg, SnCu, usw. Durch geeignete Schichtdickenverhältnisse kann auch die Lotzusammensetzung selbst, beispielsweise SnₓCu_{y}, beeinflusst werden. Die durch den Aufbau bedingte Einstellung der Lotzusammensetzung vermeidet aufwendige Prozesse zur Realisierung und Kontrolle von Lotlegierungsabscheidungen, wie z.B. SnₓCu_{y}, bzw. ersetzt sie komplett. Dies kann zu einer Kostenreduzierung bei gleichzeitiger Erhöhung der Zuverlässigkeit von Flip-Chip-Kontaktsystemen beitragen. Ferner ermöglicht die vorliegende Erfindung Kostenvorteile beim Waferbumping durch reduzierte Prozesszeiten (kleinere Schichtdicken), bei gleichzeitiger Zuverlässigkeitserhöhung durch eine stabilisierte Kontaktstelle.

Die Erfindung hat besondere Bedeutung für die Anwendungsfälle, bei denen eine Vielzahl von bevorzugt kleinen Lotkontakten (z.B. Mikrosensorsystemen, 3D Integration in der Mikroelektronik) eingesetzt werden

Bevorzugte Ausführungsbeispiele der vorliegenden Erfindung werden nachfolgend bezugnehmend auf die beiliegenden Zeichnungen näher erläutert. Es zeigen:
- Fig. 1: eine Bump-Struktur
- Fig. 2: eine schematische Ansicht eines Lötkontakts nach einer Flüssigphasenreaktion, wobei eine Teil- schicht der zweiten benetzbaren Materialschicht verblieben ist;
- Fig. 3: eine schematische Ansicht eines Lötkontakts nach einer Flüssigphasenreaktion, wobei die gesamte zweite benetzbare Materialschicht zu einer (durchgehenden) intermetallischen Schicht umgesetzte wurde);
- Fig. 4: eine schematische Ansicht eines Lötkontakts mit einer zu dünnen zweiten benetzbaren Materialschicht nach einer Flüssigphasenreaktion;
- Fig. 5: ein UBM-Pad als Lötpartner für ein Lotbump (ent- spricht Fig. 1 ohne Lot); und
- Fig. 6: eine herkömmliche Bump-Struktur.

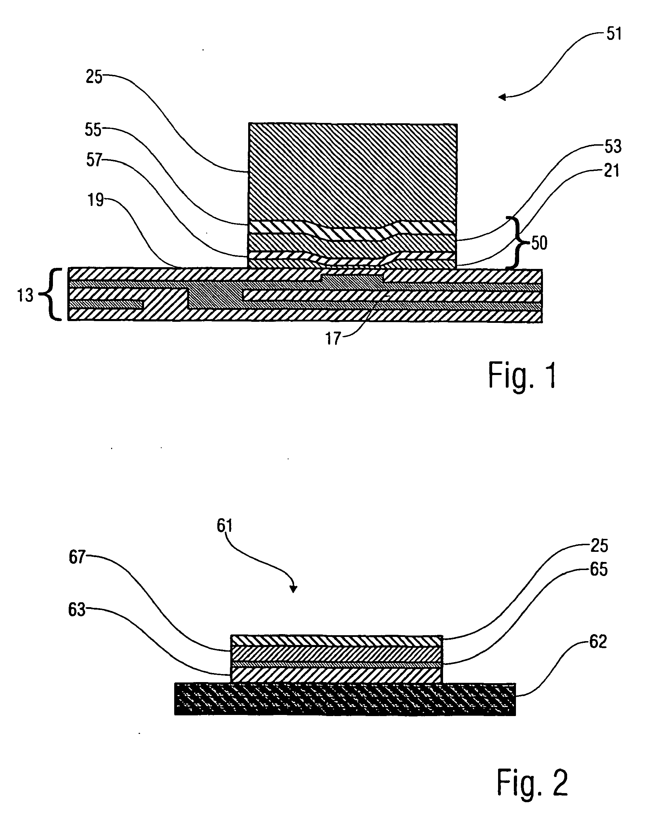

In Fig. 1 ist eine Bump-Struktur 51 auf dem Substrat 13 gezeigt. In der nachfolgenden Beschreibung der bevorzugten Ausführungsbeispiele werden gleiche oder gleichwirkende Elemente mit den gleichen Bezugszeichen versehen. Insbesondere werden Elemente, die zu denjenigen aus Fig. 6 gleich oder gleichwirkend sind mit dem gleichen Bezugszeichen versehen. Die nachfolgende Beschreibung des in Fig. 1 gezeigten Beispiels beschränkt sich dabei auf eine Darstellung der Unterschiede zu dem Aufbau nach Fig. 6.

Die Bump-Struktur 51 unterscheidet sich von der herkömmlichen Bump-Struktur 11 insbesondere dadurch, dass statt einer Materialschicht 23 eine benetzbaren Doppelschicht bestehend aus einer ersten Materialschicht 53 und einer zweiten Materialschicht 55 vorgesehen ist. Ferner ist in Fig. 1 zwischen der Haft- und Diffusionssperrschicht 21 und der ersten benetzbaren Materialschicht 53 eine optionale Galvaniksttartschicht 57 angeordnet. Die Bump-Struktur kann sich sowohl auf einem Halbleiterwafer (Fig. 1) als auch auf einem beliebigen anderen Trägersubstrat (Silizium, Leiterplatte, Glas, Folie Keramik, etc.) befinden.

Die hier gezeigte UBM 50 (Mehrlagensystem von Metall bzw. Metallschichten) aus der Haft- und Diffusionssperrschicht 21, Galvanikstartschicht 57, der ersten benetzbaren Materialschicht 53 und der zweiten benetzbaren Materialschicht 55 bestehend lässt sich beispielsweise durch physikalisch-chemische Prozesse, wie z.B. Sputter- oder galvanische Prozesse erzeugen, wobei die unterschiedlichen Metallschichten unterschiedliche metallurgische Eigenschaften gegenüber dem Lot 25 zeigen. Das Lot 25 kann dabei vorzugsweise bleifrei ausgeführt sein. Die Galvanikstartschicht 57 ist optional und dann vorgesehen, wenn die erste benetzbare Materialschicht 53 durch einen galvanischen Prozess erzeugt wird.

Durch eine geeignete Wahl der Schichtdicken und der Materialien in dem Metallisierungssystem bzw. der Materialien der ersten benetzbaren Materialschicht 53 und der zweiten benetzbaren Materialschicht 55 kann das Wachstum der sich ausbildenden intermetallischen Verbindung zwischen dem Material der ersten benetzbaren Materialschicht 53 und dem Lotmaterial bei einer metallurgischen Reaktion unterbunden werden. Ein Material der zweiten benetzbaren Materialschicht 55 weist dabei eine schnellere Bildung von intermetallischen Verbindungen in der Flüssigphasenreaktion auf als eines der Materialien der ersten benetzbaren Materialschicht 53. Dabei wird wie oben bereits erläutert eine Umsetzung des Materials der ersten benetzbaren Materialschicht 53 mit dem Lot durch eine intermetallische Verbindung, aus einem Material der zweiten benetzbaren Materialschicht 55 und dem Lotmaterial unterbunden. Im Anwendungsbeispiel bildet diese intermetallische Verbindung eine nahezu dichte Schicht.

Der in Fig. 1 gezeigte UBM-Aufbau 50 bzw. die in Fig. 1 gezeigte Bump-Struktur 51 ermöglicht somit einen Lötkontakt auszuführen, welcher hinsichtlich des Phasenwachstums speziell beim Einsatz von bleifreien Loten stabil ist und prozesstechnisch schnell und wirtschaftlich für das Wafer-Bumping von Halbleitern und elektronischen Komponenten einsetzbar ist.

Die in Fig. 1 gezeigte Bump-Struktur 51 kann dazu eingesetzt werden, den hier gezeigten Lötpartner mit einem weiteren Lötpartner zu verbinden. Hierzu wird der zweite hier nicht gezeigte Lötpartner an dem Lötkontakt bzw. der Bump-Struktur 51 positioniert und anschließend ein Reflow-Löten durchgeführt, so dass sich eine intermetallische Verbindung zwischen dem zweiten Material und dem Lotmaterial ausbildet und der hier gezeigte Lötpartner mit dem anderen Lötpartner verbunden wird. Das Verfahren wird dabei vorzugsweise so ausgeführt, dass der Schritt der Durchführung des Reflow-Lötens über einen vorbestimmten Zeitraum bei einer vorbestimmten Temperatur durchgeführt wird, so dass sich eine durchgehende bzw. weitgehend durchgehende Schicht einer intermetallischen Verbindung zwischen dem zweiten Material der zweiten benetzbaren Materialschicht 55 und dem Lotmaterial 25 bildet und keine intermetallische Verbindung zwischen dem ersten Material in der ersten benetzbaren Materialschicht 53 und dem Lotmaterial 25.

Fig 2 zeigt eine schematische Ansicht eines Lötkontakts 61 nach Durchführung einer metallurgischen Reaktion, gemäß einem Ausführungsbeispiel der vorliegenden Erfindung, der durch Reflow-Löten einer Schichtanordnung aus erster benetzbarer Materialschicht , zweiter benetzbarer Materialschicht und Lotmaterial gebildet wurde. Die zweite Materialschicht weist dabei eine solche Dicke auf, dass nach der metallurgischen Reaktion auf einem Substrat mit Haft- und Diffusionssperrschicht und Galvanikstartschicht 62 die erste Materialschicht 63 angeordnet ist, auf der ein Teil 65 der zweiten Materialschicht verblieben ist. Auf dieser Teilschicht 65 ist eine intermetallische Verbindung 67 angeordnet, die durch eine metallurgische Reaktion des Materials der zweiten Materialschicht 65 mit dem Lot gebildet wurde.

Bei dem in Fig. 2 gezeigten Lötkontakt hatte die zweite benetzbare Materialschicht vor der metallurgischen Reaktion eine große Schichtdicke, so dass diese bei der metallurgischen Reaktion nicht vollständig verbraucht wurde und die Teilschicht 65 bestehen bleibt. Somit besteht die intermetallischen Verbindung 67 lediglich aus einer Verbindung zwischen dem Material der zweiten Materialschicht und dem Lotmaterial. Besteht die zweite Materialschicht aus Kupfer und das Lotmaterial aus Zinn, so entsteht eine Cu₆Sn₅-Verbindung. Eine intermetallische Verbindung zwischen der ersten benetzbaren Materialschicht und dem Lotmaterial (bei Nickel und Zinn Ni₃Sn₄) kann nicht gebildet werden, so dass man einen zuverlässigen Lötkontakt erhält.

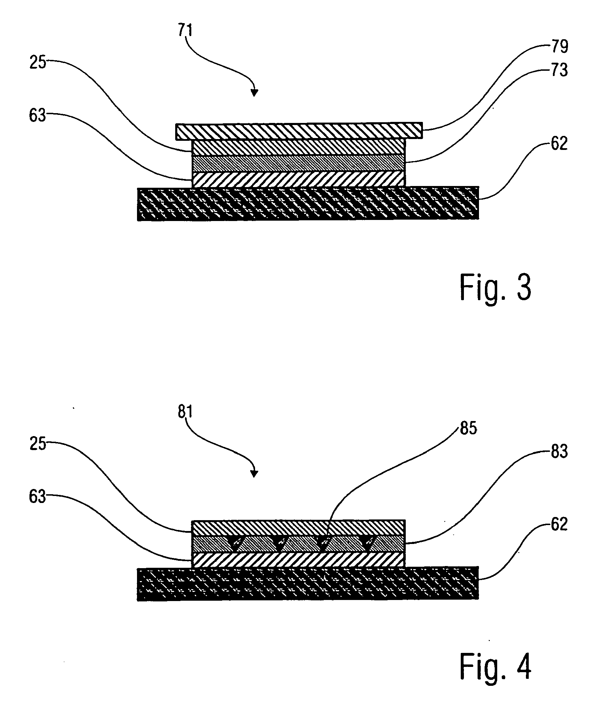

Fig.3 zeigt eine schematische Ansicht eines Lötkontakts 71 nach Durchführung einer metallurgischen Reaktion bei hoher Temperatur, gemäß einem Beispiel, welches nicht zur vorliegenden Erfindung gehört, der durch Reflow-Löten einer Schichtanordnung aus einer ersten benetzbaren Materialschicht, einer zweiten benetzbaren Materialschicht und dem Lotmaterial gebildet wurde. Die zweite Materialschicht wies dabei eine solche Dicke auf, dass bei der Flüssigphasenreaktion die zweite Materialschicht vollständig verbraucht wurde und zwischen Lotschicht 25 und erster Materialschicht 63 eine intermetallische Verbindung 73, IMC M2 angeordnet ist.

Da der Lotanteil in der intermetallischen Verbindung 73 geringer ist als er in einer intermetallischen Verbindung IMC M1 zwischen der ersten Materialschicht 63 M1 und dem Lotmaterial wäre, wird eine solche intermetallische Verbindung IMC M1 an der Grenzfläche zwischen IMC M2 und M1 nicht erzeugt. Abhängig von den verwendeten Materialien findet vielmehr an der Grenzfläche zwischen IMC M2 und M1 lediglich ein Austausch von M2 und M1 in der intermetallischen Verbindung IMC M2 bis zu einem bestimmten Sättigungswert statt.

Ist M1 Nickel, M2 Kupfer und das Lotmaterial Zinn, so bildet sich die intermetallische Verbindung als (Cu, Ni)₆Sn₅-Schicht aus.

Das in Fig. 3 gezeigte Beispiel ermöglicht die Verwendung einer dünneren zweiten benetzbaren Materialschicht 2 als das in Fig. 2 gezeigte Beispiel, wobei immer noch ein zuverlässiger Lötkontakt gewährleistet werden kann. In Fig. 3 ist ferner schematisch ein zweiter Lötpartner 79 dargestellt, der durch das Reflow-Löten mit dem Substrat 62 verbunden wird. Bei beiden Lötpartnern kann es sich dabei beispielsweise um elektronische Bauelemente, Integrierte Schaltungen oder Substrate handeln.

In Fig. 4 ist ein Vergleichsbeispiel 81 nach Durchführung eines Reflow-Lötens dargestellt, bei dem die zweite benetzbare Materialschicht eine zu geringe Stärke aufwies. Wie in Fig. 4 dargestellt ist, bildet sich dabei keine durchgehende Schicht einer intermetallischen Verbindung 83 zwischen dem Material der zweiten Materialschicht und dem Lotmaterial 25, sondern diese Schicht 83 ist von Lotnadeln 85 durchzogen, die bis zu der ersten benetzbaren Materialschicht 63, M1 reichen. Somit dringt das Lot bis zu der ersten Materialschicht 63 vor, so dass dort eine intermetallische Verbindung IMC M1 gebildet werden kann, was zur Folge hat, dass eine Zuverlässigkeit des Lötkontakts nicht mehr gewährleistet ist.

In Fig. 5 ist ein UBM-Pad bzw. Anschlusskontakt 91 gezeigt. In dem UBM-Pad 91 ist im Gegensatz zu der in Fig. 1 gezeigten Bump-Struktur kein Lotmaterial 25 vorhanden, und eine erste benetzbare Materialschicht ist mit dem Bezugszeichen 93 versehen und eine zweite benetzbare Materialschicht mit dem Bezugszeichen 95. Über das UBM-Pad 91 wird eine elektrische und/oder mechanische Verbindung zu einem hier nicht gezeigten Lötpartner hergestellt. Dabei befindet sich ein hier nicht gezeigtes Lotmaterial auf einem Lötkontakt an dem Lötpartner.

Die vorliegende Erfindung wurde anhand einer Implementierung untersucht, bei der ein System, wie es in Fig. 1 gezeigt ist, verwendet wurde. Dabei wurde als Haft- und Diffusionssperrschicht 57 eine TiW-Schicht verwendet, die aufgesputtert wurde und daher mit TiWₛₚ bezeichnet wird. Als Galvanikstartschicht 21 wurde eine Cu-Schicht Cuₛₚ aufgesputtert. Auf der Galvanikstartschicht 21 wurden dann nacheinander eine Nickelschicht Niₑₚ als erste benetzbare Materialschicht 53 und eine Kupferschicht Cuₑₚ als zweite benetzbare Materialschicht 55 galvanisch abgeschieden.

Als Lotmaterial wurde Sn, eine SnAg-, und eine eutektische SnCu-Legierung eingesetzt. Kleine Sn-Bumps mit einer Höhe von 23 µm bildeten den Schwerpunkt der Auswertung. Die Nickelschicht Niₑₚ wies eine Dicke von 1,5 µm auf. Bei einem ersten Beispiel wurde eine Kupferschicht Cuₑₚ mit einer Dicke von 150 nm verwendet, während bei einem zweiten Beispiel eine Kupferschicht Cuₑₚ mit einer Dicke von 500 nm verwendet wurde. Dabei stellt eine Cu-Schichtdicke von 500 nm die obere Grenze der Löslichkeit von Cu in Sn bei dieser Bumphöhe (23 µm Sn) während des Reflow-Lötens dar. Das Löten geschieht bei einer Temperatur von 250°C. Die entsprechende Löslichkeit ist aus dem Phasendiagramm ablesbar, gemäß U.R. Kattner u.a.(Z. Metallkd., Vol. 92, No. 7, Juli 2001, Seiten 740 bis 746). Würde eine 150 nm dicke Schicht Cu vollständig in Sn gelöst, entspräche dies der eutektischen Zusammensetzung.

Die entsprechend aufgebauten Lotbumps wurden einer Alterung unterzogen, wobei sie vorher für 120 s bei 250°C umgeschmolzen worden waren (Flüssigphasenreaktion). Die darauf folgende thermische Alterung (Festphasenreaktion) wurde bei 150°C für bis zu 1000 h durchgeführt.

Ausgehend von dem beschriebenen Metallisierungsschema TiWₛₚCuₛₚ-Niₑₚ-CUₑₚ als Untermetallisierung und Sn als Lot wurde ein stabiles Interface zwischen Ni und Lot durch die Ausbildung der intermetallischen Verbindung (CuNi)₆Snₛ erzielt. (CuNi)₆Sn₅ entsteht durch die Umsetzung von Cu, wenn es in ausreichender Menge in der Grenzschicht vorhanden ist (optimierte Cu-Schichtdicke), und Lot in der Flüssigphasenreaktion. Während der anschließenden thermischen Alterung wurde keine Veränderung an dem Interface festgestellt, die eine Beeinträchtigung des Kontakts darstellen würde.

Im Gegensatz dazu zeigte sich bei einem Vergleichsbeispiel mit einer zu dünnen Cu-Schicht, dass längerfristig ein vollständiger, wenn auch verlangsamter Verbrauch der ersten Materialschicht M1 aus Nickel auftritt.

Die durchgeführten Untersuchungen sind in "Effect of the Cu Thickness on the Stability of a Ni/Cu Bilayer UBM of Lead Free Microbumps during Liquid and Solid State Aging", von C. Jurenka Wolf, Engelmann, Reichl u.a., 55th Electronic Components & Technology Conference (ECTC 2005), Lake Buena Vista, F1 (USA), May 31 - June 3, 2005, Proc. Seiten 89 - 93, veröffentlicht.

In diesem Artikel wird beschrieben, dass bei geeigneter Wahl der Schichtdicke der zweiten Materialschicht aus Cu eine nahezu durchgehende Trennschicht aus (Cu,Ni)₆Sn₅ zwischen Lot und Nickel erzeugt wird, wobei sich die Zusammensetzung dieser Schicht während der nachfolgenden thermischen Alterung nicht änderte. Diese Zusammensetzung ist abhängig von der Dauer des Reflow-Prozesses, der gewählten Temperatur und der Dimensionierung der Schichtdicken.

Die erste benetzbare Materialschicht 53 und die zweite benetzbare Materialschicht 55 können beispielsweise mittels Sputterprozessen, Dampfprozessen oder galvanischer bzw. elektrochemischer Prozesse aufgebracht werden (Fig. 1). Die vorliegende Erfindung ist jedoch nicht auf solche Verfahren zur Aufbringung der ersten Materialschicht 53 und der zweiten Materialschicht 55 begrenzt, wobei beliebige andere Verfahren Anwendung finden können. Das Lot kann beispielsweise mittels galvanischer Prozesse, Aufdampfverfahren, Lotpastendruck oder durch Plazieren von Lot-Preforms (z.B. Lotkugeln) aufgebracht werden. Bei den Ausführungsbeispielen oben sind in der Bump-Struktur 51 zwei Materialschichten 53 und 55 (Fig. 1) zwischen Lotmaterial und Haftschicht angeordnet. Jedoch kann auch eine größere Anzahl von Materialschichten zwischen der ersten Materialschicht und dem Lot angeordnet werden, die bezüglich der ersten Materialschicht vergleichbare Eigenschaften aufweisen wie die zweite Materialschicht .

Bei den Ausführungsbeispielen oben sind spezifische an Reflow-Löttemperatur, Materialien und Lotmaterialmasse angepasste Schichtdicken verwendet worden. Abhängig von den Gegebenheiten können jedoch andere Schichtdicken verwendet werden, solange gewährleistet bleibt, dass sich eine Trennschicht der beschriebenen Art zwischen einer der benetzbaren Materialschichten und dem Lot ausbildet. In den Ausführungsbeispielen oben wird die Bump-Struktur 51 vorzugsweise eingesetzt, um Flip-Chip-Kontaktierungen auszuführen. Jedoch ist eine beliebige Nutzung einer Metallisierung, die der Bump-Struktur 51 entspricht, eine hierzu weitere Anwendung.

Statt Nickel und Kupfer für die erste und zweite benetzbare Materialschicht könnten beliebige geeignete Metalle oder Metallschichtsysteme oder Metalllegierungen verwendet werden, die die definierten Eigenschaften zueinander aufweisen.

Die Haft- und Diffusionssperrschicht und die Galvanikstartschicht können jeweils unterschiedliche Schichtdicken aufweisen. Typisch liegen diese im Anwendungsfeld der Mikroelektronik im Bereich von einigen Nanometern. Die Dicke der ersten benetzbaren Materialschicht ist unkritisch und liegt in diesem Anwendungsgebiet im Bereich von einigen Mikrometern (typ. 1 - 100 µm). Die zweite benetzbare Materialschicht kann eine Schichtdicke in einem Bereich von wenigen Nanometern bis zu einigen Mikrometern aufweisen. Um einen Schichtaufbau mit einer möglichst geringen Dicke implementieren zu können (reduzierte Prozesszeiten), ist die Dicke der zweiten Materialschicht vorzugsweise geringer als die Dicke der ersten Materialschicht. Im Einzelfall müssen die Schichtdicken speziell der zweiten Materialschicht 2 dem Lotvolumen und damit der Bumpgröße angepasst werden.

## Patentansprüche

1. Verfahren zum Herstellen einer Lötverbindung zwischen einem UBM-Pad (91) das eine erste Materialschicht (93) und eine zweite Materialschicht (95) aufweist, wobei eine Haft- und Diffusionssperrschicht (21) an der der zweiten Materialschicht (95) *abgewandten Seite der* ersten Materialschicht (93) angeordnet ist und einem Lötpartner, mit folgendern Schritt :
Durchführen eines Reflow-Lötens zur Erzeugung einer intermetallischen Verbindung in einem Zustand, bei dem ein Lötmaterial zwischen dem Lötpartner und dem UBM-Pad (91) an dem Lötpartner oder dem UBM-Pad (91) positioniert ist, zwischen dem zweiten Material und dem Lotmaterial (25) zur Zusammenfügung des UBM-Pad (91) und des Lötpartners,
wobei
die erste Materialschicht (93) ein erstes Material aufweist; und
die zweite Materialschicht (95) ein zweites Material aufweist und selbst eine Endschicht darstellt oder zwischen einer Endschicht und der ersten Materialschicht (93) angeordnet ist;
wobei das erste Material und das zweite Material bezüglich des Lotmaterials (25) Eigenschaften besitzen, so dass die Anwesenheit des zweiten Materials (95) metallurgische Reaktionen des ersten Materials (93) mit dem Lotmaterial (25) im gesamten Temperaturbereich des Verbindens und des Betriebs des aufgebauten elektronischen Bauelements unterbindet, die der Zuverlässigkeit der Gesamtverbindung abträglich sind,
wobei das Lotmaterial (25), das erste Material und das zweite Material solche sind,
dass bei einer metallurgischen Reaktion das zweite Material und das Lotmaterial (25) eine höhere Bildungsgeschwindigkeit einer intermetallischen Verbindung aufweisen als das erste Material und das Lotmaterial; und
dass ein Anteil des Lotmaterials (25) in einer intermetallischen Verbindung zwischen dem zweiten Material und dem Lotmaterial (25) geringer ist als ein Anteil des Lotmaterials in einer intermetallischen Verbindung zwischen dem ersten Material und dem Lotmaterial (25) wäre;
**dadurch gekennzeichnet, dass**
die zweite Materialschicht (95) eine solche Dicke aufweist, dass ein Verhältnis der Masse des zweiten Materials zur Masse des Lotmaterials größer ist als die Löslichkeit des zweiten Materials in dem Lotmaterial bei einer Temperatur, bei der das Reflow-Löken stattfindet, so dass die Dicke sicherstellt, dass bei einer metallurgischen Reaktion eine derartige Schicht einer intermetallischen Verbindung, die das Lotmaterial (25) und das zweite Material aufweist, zwischen dem Lotmaterial (25) und der ersten Materialschicht (93) gebildet wird, so dass die Bildung einer intermetallischen Verbindung zwischen dem ersten Material und dem Lotmaterial (25) nicht auftritt.

2. Verfahren gemäß Anspruch 1, bei dem das erste Material. Nickel aufweist.

3. Verfahren gemäß einem der Ansprüche 1 oder 2, bei dem das zweite Material Kupfer aufweist.

4. Verfahren gemäß einem der Ansprüche 1 bis 3, bei dem das Lotmaterial (25) Zinn oder eine Zinn-Legierung aufweist.

5. Verfahren gemäß einem der Ansprüche 1 bis 4, bei dem die zweite Materialschicht (95) dünner als die erste Materialschicht (93) ist.

6. Verfahren gemäß Anspruch 1, bei dem die Haft- und Diffusionssperrschicht (21) eine Schichtdicke unter 1 µm aufweist.

7. Verfahren gemäß einem der Ansprüche 1 bis 6, bei dem eine Mehrzahl von Materialschichten zwischen dem Lotmaterial (25) und der ersten Materialschicht (93) angeordnet ist.

8. Verfahren gemäß einem der Ansprüche 1 bis 7, bei dem ferner eine Galvanikstartschicht (57) auf einer der zweiten Materialschicht (95) abgewandten Seite der ersten Materialschicht (93) vorgesehen ist.

9. Verfahren gemäß Anspruch 1, bei dem ein Anschlusspad (17) mit der ersten Materialschicht (93) elektrisch-leitend verbunden ist, und bei dem die erste Materialschicht (93) zwischen dem Anschlusspad und der zweiten Materialschicht (95) angeordnet ist.

## Claims

1. Method of creating a solder joint between a UBM pad (91) having a first material layer (93) and a second material layer (95), wherein an adhesion and diffusion barrier layer (21) is arranged on the side of the first material layer (93) facing away from the second material layer (95), and a solder partner, comprising:
performing reflow soldering for creating an intermetallic compound in a state where a solder material is positioned between the solder partner and the UBM pad (91) at the solder partner or the UBM pad (91), between the second material and the solder material (25) for joining the UBM pad (91) and the solder partner, wherein
the first material layer (93) comprises a first material; and
the second material layer (95) comprises a second material and itself represents an end layer or is arranged between an end layer and the first material layer (93);
wherein the first material and the second material exhibit such characteristics with regard to the solder material (25) that the presence of the second material (95) prevents any metallurgical reactions of the first material (93) with the solder material (25) in the entire temperature range of joining and of operating the assembled electronic device, which are detrimental to the reliability of the overall joint,
wherein the solder material (25), the first material and the second material are such
that in a metallurgical reaction the second material and the solder material (25) comprise higher rates of forming an intermetallic compound than the first material and the solder material; and
that a proportion of the solder material (25) in an intermetallic compound including the second material and the solder material (25) is smaller than a proportion of the solder material in an intermetallic compound including the first material and the solder material (25) would be;
**characterized in that** the second material layer (95) has such a thickness that a ratio of the mass of the second material to the mass of the solder material is higher than the solubility of the second material in the solder material at a temperature where reflow soldering takes place, such that the thickness ensures that in a metallurgical reaction such a layer of an intermetallic compound, which comprises the solder material (25) and the second material, is formed between the solder material (25) and the first material layer (93), so that the formation of an intermetallic compound including the first material and the solder material (25) does not occur.

2. Method according to claim 1, wherein the first material comprises nickel.

3. Method according to one of claims 1 or 2, wherein the second material comprises copper.

4. Method according to one of claims 1 to 3, wherein the solder material (25) comprises tin or a tin alloy.

5. Method according to one of claims 1 to 4, wherein the second material layer (95) is thinner than the first material layer (93).

6. Method according to claim 1, wherein the adhesion and diffusion barrier layer (21) has a layer thickness below 1 µm.

7. Method according to one of claims 1 to 6, wherein a plurality of material layers is arranged between the solder material (25) and the first material layer (93).

8. Method according to one of claims 1 to 7, wherein a further electrodeposition starting layer (57) is provided on a side of the first material layer (93) facing away from the second material layer (95).

9. Method according to claim 1, wherein a terminal pad (17) is connected to the first material layer (93) in an electrically conductive manner, and wherein the first material layer (93) is arranged between the terminal pad and the second material layer (95).

## Revendications

1. Procédé de production d'une liaison de brasage entre une pastille UBM (91) présentant une première couche de matériau (93) et une deuxième couche de matériau (95), une couche d'arrêt d'adhérence et de diffusion (21) étant disposée du côté de la première couche de matériau (93) opposé à la deuxième couche de matériau (95), et un partenaire de brasage, à l'étape suivante consistant à:
réaliser un brasage à reflux, pour générer une liaison entre métaux dans un état où un matériau de brasage est disposé entre le partenaire de brasage et la pastille UBM (91), sur le partenaire de brasage ou la pastille UBM (91), entre le deuxième matériau et le matériau de brasage (25), pour assembler le pastille UBM (91) et le partenaire de brasage,
la première couche de matériau (93) présentant un premier matériau; et
la deuxième couche de matériau (95) présentant un deuxième matériau et représentant elle-même une couche finale ou étant disposée entre une couche finale et la première couche de matériau (93);
le premier matériau et le deuxième matériau possédant, par rapport au matériau de brasage, des qualités telles que la présence du deuxième matériau (95) empêche des réactions métallurgiques du premier matériau (93) avec le matériau de brasage (25) dans toute la plage de températures de la liaison et du fonctionnement du composant électronique construit qui dégradent la fiabilité de l'assemblage total,
le matériau de brasage (25), le premier matériau et le deuxième matériau étant tels que,
en cas de réaction métallurgique, le deuxième matériau et le matériau de brasage (25) présentent une vitesse de formation d'une liaison entre métaux plus grande que le premier matériau et le matériau de brasage; et
une part du matériau de brasage (25) dans une liaison entre métaux entre le deuxième matériau et le matériau de brasage (25) serait plus petite qu'une part du matériau de brasage dans une liaison entre métaux entre le premier matériau et matériau de brasage (25);
**caractérisé par le fait que** la deuxième couche de matériau (95) présente une épaisseur telle qu'un rapport entre la masse du deuxième matériau et la masse du matériau de brasage soit inférieur à la solubilité du deuxième matériau dans le matériau de brasage à une température à laquelle a lieu le brasage à reflux, de sorte que l'épaisseur assure qu'en cas de réaction métallurgique soit formée une couche d'une liaison entre métaux présentant le matériau de brasage (25) et le deuxième matériau entre le matériau de brasage (25) et la première couche de matériau (93) telle que la formation d'une liaison entre métaux entre le premier matériau et le matériau de brasage (25) ne se produise pas.

2. Procédé selon la revendication 1, dans lequel le premier matériau présente du nickel.

3. Procédé selon l'une des revendications 1 ou 2, dans lequel le deuxième matériau présente du cuivre.

4. Procédé selon l'une des revendications 1 à 3, dans lequel le matériau de brasage (25) présente de l'étain ou un alliage d'étain.

5. Procédé selon l'une des revendications 1 à 4, dans lequel la deuxième couche de matériau (95) est plus mince que la première couche de matériau (93).

6. Procédé selon la revendication 1, dans lequel la couche d'arrêt d'adhérence et de diffusion (21) présente une épaisseur de couche de moins de 1 µm.

7. Procédé selon l'une des revendications 1 à 6, dans lequel un nombre de couches de matériau sont disposées entre le matériau de brasage (25) et la première couche de matériau (93).

8. Procédé selon l'une des revendications 1 à 7, dans lequel une couche d'amorce galvanique (57) est par ailleurs prévue d'un côté de la première couche de matériau (93) opposé à la deuxième couche de matériau (95).

9. Procédé selon la revendication 1, dans lequel une pastille de raccordement (17) est connectée de manière électroconductrice à la première couche de matériau (93), et dans lequel la première couche de matériau (93) est disposée entre la pastille de raccordement et la deuxième couche de matériau (95).
